# EUROPEAN PATENT SPECIFICATION

(11) **EP 3 620 945 B1**
(45) Date of publication and mention of the grant of the patent: **24.09.2025**
(21) Application number: 19185780.4
(22) Date of filing: 11.07.2019
(51) Int. Cl.: G06N 3/045, G06F 30/27, G06N 3/08

(54) **OBSTACLE DISTRIBUTION SIMULATION METHOD, DEVICE AND TERMINAL BASED ON MULTIPLE MODELS**
VERFAHREN, VORRICHTUNG UND ENDGERÄT ZUR SIMULATION EINER HINDERNISVERTEILUNG AUF BASIS MEHRERER MODELLE
PROCÉDÉ, DISPOSITIF ET TERMINAL DE SIMULATION DE DISTRIBUTION D'OBSTACLES BASÉS SUR PLUSIEURS MODÈLES

(30) Priority: 07.09.2018 CN 201811044615
(43) Date of publication of application: 11.03.2020
(73) Proprietor: Baidu Online Network Technology (Beijing) Co., Ltd., Beijing 100085 (CN)
(72) Inventor: FANG, Jin, Beijing, 100085 (CN); YAN, Feilong, Beijing, 100085 (CN); ZHANG, Feihu, Beijing, 100085 (CN); YANG, Ruigang, Beijing, 100085 (CN); WANG, Liang, Beijing, 100085 (CN); MA, Yu, Beijing, 100085 (CN)
(74) Representative: Nederlandsch Octrooibureau

(56) References cited:
- WO-A1-2018/138584
- US-A1- 2018 095 475
- US-B1- 9 760 806
- CHRISTOPH GUSTAV KELLER ET AL: "Real-time recognition of U.S. speed signs", INTELLIGENT VEHICLES SYMPOSIUM, 2008 IEEE, IEEE, PISCATAWAY, NJ, USA, 4 June 2008 (2008-06-04), pages 518 - 523, XP031318927, ISBN: 978-1-4244-2568-6
- KURAMOTO AKISUE ET AL: "Mono-Camera based 3D Object Tracking Strategy for Autonomous Vehicles", 2018 IEEE INTELLIGENT VEHICLES SYMPOSIUM (IV), IEEE, 26 June 2018 (2018-06-26), pages 459 - 464, XP033423428, [retrieved on 20181018], DOI: 10.1109/IVS.2018.8500482

## Description

### FIELD OF THE DISCLOSURE

The present disclosure relates to the technical field of computers, and in particular to an obstacle distribution simulation method, device and terminal based on multiple models.

### BACKGROUND OF THE DISCLOSURE

Christoph Gustav Keller et al, "Real-Time Recognition of U.S. Speed Signs," 2008 IEEE INTELLIGENT VEHICLES SYMPOSIUM, Eindhoven University of Technology, Eindhoven, The Netherlands, 4 June 2008, pages 518-523, discloses a camera-based system for detection, tracking, and classification of U.S. speed signs, and specifically discloses: using multiple connected stages and iteratively reducing the number of pixels to process for recognition. Possible sign locations are detected using a fast, shape-based interest operator. Remaining objects other than speed signs are discarded using a classifier similar to the Viola-Jones detector. Classification results from tracked candidates are utilized to improve recognition accuracy.

US9760806B1 discloses a method and a system for vision-centric deep-learning-based road situation analysis are provided. The method can include: receiving real-time traffic environment visual input from a camera; determining, using a ROLO engine, at least one initial region of interest from the real-time traffic environment visual input by using a CNN training method; verifying the at least one initial region of interest to determine if a detected object in the at least one initial region of interest is a candidate object to be tracked; using LSTMs to track the detected object based on the real-time traffic environment visual input, and predicting a future status of the detected object by using the CNN training method; and determining if a warning signal is to be presented to a driver of a vehicle based on the predicted future status of the detected object.
US 2018/095475 A1 discloses determining the spatial position of detected objects detected by an autonomous vehicle by machine learning.

In an off-line state of a high-precision map, labelling data of obstacles in the map may be collected. The labelling data includes a position where an obstacle is currently located, an orientation, an ID and a type of the obstacle, and so on. The type of the obstacle may be a dynamic obstacle such as a vehicle, a pedestrian and a riding person, or a static obstacle such as a cone cylinder. How to simulate the number of obstacles and the position distribution of the obstacles so as to resemble the real conditions as much as possible is drawing more and more attention from those skilled in the art.

In the existing technical solutions, simulation is typically performed by using regular arrangement of obstacles with the aid of a high-precision map. Examples of regular arrangement of obstacles include: arrangement of vehicles in a direction of a lane line, and random arrangement of pedestrians. However, very limited scenarios can be presented based on regular arrangement of obstacles. Since the high-precision map includes only main roads and includes no side roads or branch roads, a simulation result of the position distribution of the same type of obstacles and a simulation result of the number distribution of different types of obstacles differ from real conditions greatly. In addition, the regular arrangement of obstacles cannot present all the possible cases in a real scenario in an exhaustive manner, resulting in a low coverage.

### SUMMARY OF THE DISCLOSURE

The invention is defined in the independent claims.

### BRIEF DESCRIPTION OF THE DRAWINGS

Unless otherwise specified, identical or similar parts or elements are denoted by identical reference signs throughout several figures of the accompanying drawings. The drawings are not necessarily drawn to scale. It should be understood that these drawings merely illustrate some embodiments of the present disclosure, and should not be construed as limiting the scope of the disclosure.
FIG. 1 is a flowchart of an obstacle distribution simulation method based on multiple models according to an embodiment of the present disclosure;
FIG. 2 is a schematic diagram of a boundary box of a simulation obstacle according to an embodiment of the present disclosure;
FIG. 3 is a block diagram showing the structure of an obstacle distribution simulation device based on multiple models according to an embodiment of the present disclosure;
FIG. 4 is a block diagram showing the structure of a simulation obstacle position distribution module according to an embodiment of the present disclosure; and
FIG. 5 is a schematic diagram of an obstacle distribution simulation terminal based on multiple models according to an embodiment of the present disclosure.

### DETAILED DESCRIPTION OF THE EMBODIMENT(S) OF THE DISCLOSURE

Hereinafter, only some exemplary embodiments are simply described. Accordingly, the drawings and the description should be considered as illustrative in nature instead of being restrictive.

### First Embodiment

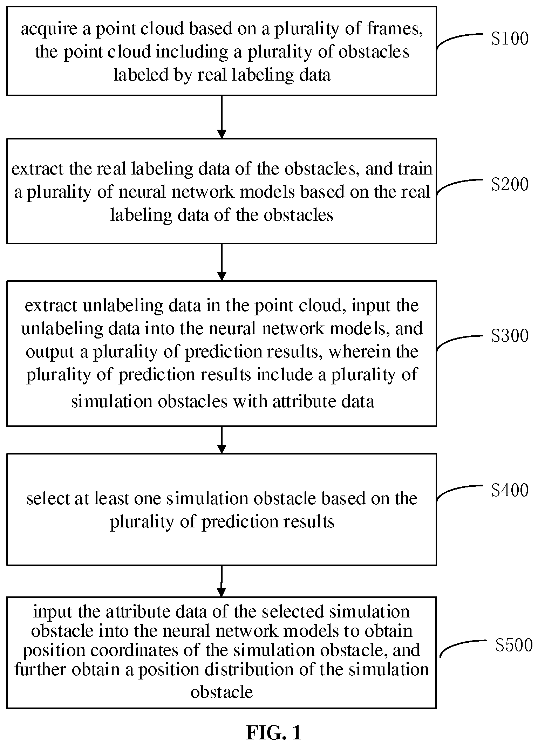

In a specific embodiment, as shown in FIG. 1, an obstacle distribution simulation method based on multiple models is provided, which includes steps S100 to S500.

At Step S100, a point cloud based on a plurality of frames is acquired, the point cloud including a plurality of obstacles labelled by real labelling data.

When an acquisition vehicle moves according to a movement rule, the acquisition vehicle may obtain a point cloud based on a plurality of frames, by scanning the surrounding obstacles using radar. The acquisition vehicle may move along a main road or along a specified side road. The point cloud may also be obtained directly from the outside.

At Step S200, the real labelling data of the obstacles are extracted, and a plurality of neural network models are trained based on the real labelling data of the obstacles.

The obstacles in each frame of the point cloud are labelled based on absolute coordinates of the obstacles, so each obstacle has corresponding real labelling data. Specifically, according to an embodiment, the absolute coordinates of the acquisition vehicle in the world coordinate system are acquired. In each frame of the point cloud, a point cloud coordinate system is established by taking the acquisition vehicle as the origin, and the relative coordinates of each obstacle with respect to the acquisition vehicle are calculated. Based on the absolute coordinates of the acquisition vehicle and the relative coordinates of the obstacle, the absolute coordinates of the obstacle in the world coordinate system can be obtained. The obstacle is labelled based on the absolute coordinates of the obstacle, the real labelling data of the obstacle including the absolute coordinates of the obstacle. Multiple neural network models are designed based on the real labelling data of the obstacles. The multiple neural network models have the same function, but have different network structures and different parameters. Common network structures include VGGnet (Visual Geometry Group), ResNet (Deep residual network, GoogleNe), and so on. The parameters correspond to the network structures.

At Step S300, unlabelling data in the point cloud are extracted, the unlabelling data are input into the neural network models, and a plurality of prediction results are output, wherein the plurality of prediction results include a plurality of simulation obstacles with attribute data.

Not all the obstacles are labelled in each frame of the point cloud, and the unlabelled obstacles each have absolute coordinates, which constitute unlabelling data in the point cloud. The unlabelling data are input into multiple neural network models to predict the simulation obstacles. The attribute data of each of the simulation obstacles include an identity recognition ID, a type and an orientation of the simulation obstacle, and so on. It should be noted that the prediction results obtained from different neural network models are different. That is, the number, the type and so on of the simulation obstacles may be different in different prediction results.

At Step S400, at least one simulation obstacle is selected based on the plurality of prediction results.

At Step S500, the attribute data of the selected simulation obstacle are input into the neural network models to obtain position coordinates of the simulation obstacle, and further obtain a position distribution of the simulation obstacle.

According to the embodiment, the position diversity of the simulation obstacles is increased, such that a simulation result of the position distribution of the simulation obstacles and a simulation result of the number distribution of the simulation obstacles are closer to real conditions.

In an embodiment, after outputting a plurality of prediction results, the method further includes:
outputting confidences corresponding to the respective prediction results; and
determining whether the confidences are greater than a threshold, and reserving a prediction result with a confidence greater than the threshold.

Through the prediction of the neural network model, not only the prediction result is output, but also the confidence corresponding to the prediction result is output. The confidence is used to indicate reliability of the prediction result. The confidence corresponding to the prediction result is determined, a prediction result with a confidence greater than the threshold is reserved, and the prediction result having a confidence less than the threshold is discarded.

In an embodiment, selecting at least one simulation obstacle based on the plurality of prediction results includes:
determining whether the plurality of prediction results include the same simulation obstacle, and selecting the same simulation obstacle in a case that the plurality of prediction results include the same simulation obstacle.

In an example, the neural network models include a first model, a second model and a third model. The unlabelling data are input into each of the first model, the second model, and the third model to obtain attribute A data, attribute B data, and attribute C data respectively. If the attribute A data, attribute B data, and attribute C data all indicate the same obstacle X, the obstacle X is selected as the simulation obstacle. Alternatively, if the number of prediction results which indicate the same obstacle is greater than or equal to a threshold number, the obstacle is selected as the simulation obstacle. For example, if both the attribute A data and the attribute B data indicate another obstacle Y, and the threshold number is 2, then the obstacle Y is selected as the simulation obstacle.

In an embodiment, obtaining position coordinates of the simulation obstacles according to the neutral network models, includes:
inputting the attribute data of the selected simulation obstacle into the neural network models to obtain position coordinates of the simulation obstacle, which includes:
inputting the attribute data of the selected simulation obstacle into the neural network models to obtain a plurality of boundary boxes of the simulation obstacle;
obtaining lengths and widths of the boundary boxes of the simulation obstacle;
calculating an average length value and an average width value based on the lengths and widths of the boundary boxes; and
obtaining center coordinates of an average boundary box based on the average length value and the average width value, to cause the center coordinates to be represented as position coordinates of the simulation obstacle.

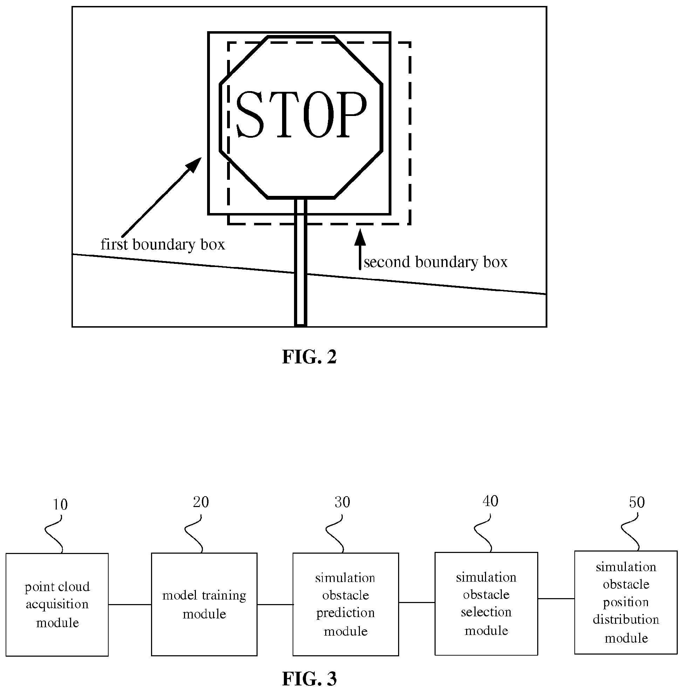

As shown in FIG. 2, a "STOP" simulation obstacle is taken as an example for illustration. A first boundary box and a second boundary box for the "STOP" simulation obstacle are acquired by calculation of two neural network models. The position coordinates of the simulation obstacle are calculated using the first boundary box and the second boundary box.

### Second Embodiment

As shown in FIG. 3, an obstacle distribution simulation device based on multiple models is provided according to another specific embodiment, which includes:
a point cloud acquisition module 10, configured to acquire a point cloud based on a plurality of frames, the point cloud including a plurality of obstacles labelled by real labelling data;
a model training module 20, configured to extract the real labelling data of the obstacles, and train a plurality of neural network models based on the real labelling data of the obstacles;
a simulation obstacle prediction module 30, configured to extract unlabelling data in the point cloud, input the unlabelling data into the neural network models, and output a plurality of prediction results, wherein the plurality of prediction results include a plurality of simulation obstacles with attribute data;
a simulation obstacle selection module 40, configured to select at least one simulation obstacle based on the plurality of prediction results; and
a simulation obstacle position distribution module 50, configured to input the attribute data of the selected simulation obstacle into the neural network models to obtain position coordinates of the simulation obstacle, and further obtain a position distribution of the simulation obstacle.

In an embodiment, the device further includes:
a confidence determination module, configured to output confidences corresponding to the respective prediction results, determine whether the confidences are greater than a threshold, and reserve a prediction result with a confidence greater than the threshold.

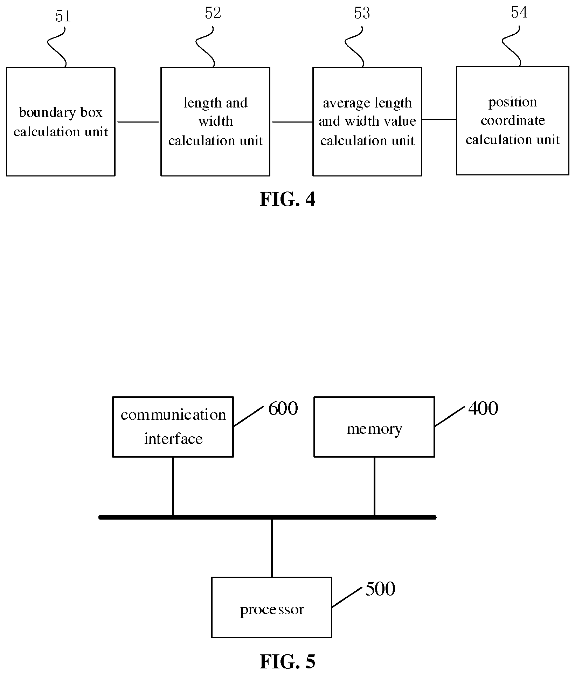

In an embodiment, as shown in FIG. 4, the simulation obstacle position distribution module 50 includes:
a boundary box calculation unit 51, configured to input the attribute data of the selected simulation obstacle into the neural network models to obtain a plurality of boundary boxes of the simulation obstacle;
a length and width calculation unit 52, configured to obtain lengths and widths of the boundary boxes of the simulation obstacle;
an average length and width value calculation unit 53, configured to calculate an average length value and an average width value based on the lengths and widths of the boundary boxes; and
a position coordinate calculation unit 54, configured to obtain center coordinates of an average boundary box based on the average length value and the average width value, to cause the center coordinates to be represented as position coordinates of the simulation obstacles.

### Third embodiment

As shown in FIG. 5, an obstacle distribution simulation terminal based on multiple models is provided according to an embodiment of the present disclosure, which includes:
a memory 400 and a processor 500, wherein a computer program that can run on the processor 500 is stored in the memory 400; when the processor 500 executes the computer program, the obstacle distribution simulation method based on multiple models according to the above embodiment is implemented; the number of the memory 400 and the processor 500 may each be one or more; and
a communication interface 600, configured to enable the memory 400 and the processor 500 to communicate with an external device.

The memory 400 may include a high-speed RAM memory, or may also include a non-volatile memory, such as at least one disk memory.

If the memory 400, the processor 500 and the communication interface 600 are implemented independently, the memory 400, the processor 500 and the communication interface 600 may be connected to each other via a bus so as to realize mutual communication. The bus may be an industry standard architecture (ISA) bus, a peripheral component interconnect (PCI) bus, an extended industry standard architecture (EISA) bus, or the like. The bus may be categorized into an address bus, a data bus, a control bus or the like. For ease of illustration, only one bold line is shown in FIG. 5 to represent the bus, but it does not mean that there is only one bus or only one type of bus.

Optionally, in a specific implementation, if the memory 400, the processor 500 and the communication interface 600 are integrated on one chip, then the memory 400, the processor 500 and the communication interface 600 can complete mutual communication through an internal interface.

### Fourth embodiment

An embodiment of the present disclosure provides a computer readable storage medium having a computer program stored thereon which, when executed by a processor, implements the obstacle distribution simulation method based on multiple models described in any of the above embodiments.

Any process or method described in the flowcharts or described otherwise herein may be construed as representing a module, segment or portion including codes for executing one or more executable instructions for implementing particular logical functions or process steps. The scope of the preferred embodiments of the present disclosure includes additional implementations in which functions may be implemented in an order that is not shown or discussed, including in a substantially concurrent manner or in a reverse order based on the functions involved. All these should be understood by those skilled in the art to which the embodiments of the present disclosure belong.

The logics and/or steps represented in the flowcharts or otherwise described herein for example may be considered as an ordered list of executable instructions for implementing logical functions. They can be specifically embodied in any computer readable medium for use by an instruction execution system, apparatus or device (e.g., a computer-based system, a system including a processor, or another system that can obtain instructions from the instruction execution system, apparatus or device and execute these instructions) or for use in conjunction with the instruction execution system, apparatus or device. For the purposes of the present specification, "computer readable medium" can be any means that can contain, store, communicate, propagate or transmit programs for use by an instruction execution system, apparatus or device or for use in conjunction with the instruction execution system, apparatus or device. More specific examples (non-exhaustive list) of computer readable storage medium at least include: electrical connection parts (electronic devices) having one or more wires, portable computer disk cartridges (magnetic devices), random access memory (RAM), read only memory (ROM), erasable programmable read-only memory (EPROM or flash memory), fiber optic devices, and portable read only memory (CDROM). In addition, the computer-readable storage medium may even be a paper or other suitable medium on which the programs can be printed. This is because for example the paper or other medium can be optically scanned, followed by editing, interpretation or, if necessary, other suitable ways of processing so as to obtain the programs electronically, which are then stored in a computer memory.

It should be understood that individual portions of the present disclosure may be implemented in the form of hardware, software, firmware, or a combination thereof. In the above embodiments, a plurality of steps or methods may be implemented using software or firmware stored in a memory and executed by a suitable instruction execution system. For example, if they are implemented in hardware, as in another embodiment, any one or a combination of the following techniques known in the art may be used: discrete logic circuits having logic gate circuits for implementing logic functions on data signals, application-specific integrated circuits having suitable combined logic gate circuits, programmable gate arrays (PGA), field programmable gate arrays (FPGA), etc.

Those skilled in the art may understand that all or part of the steps carried in the method of the foregoing embodiments may be implemented by using a program to instruct the relevant hardware, and the program may be stored in a computer readable storage medium. When executed, the program includes one or a combination of the steps in the method embodiments.

In addition, individual functional units in various embodiments of the present disclosure may be integrated in one processing module, or individual units may also exist physically and independently, or two or more units may also be integrated in one module. The above integrated module can be implemented in the form of hardware or in the form of a software functional module. The integrated module may also be stored in a computer readable storage medium if it is implemented in the form of a software function module and sold or used as a stand-alone product. The storage medium may be a read-only memory, a magnetic disk or an optical disk, etc.

## Claims

1. A computer-implemented obstacle distribution simulation method based on multiple models, comprising:
acquiring (S100) a plurality of frames of point cloud by an acquisition vehicle moving according to a movement rule by scanning surrounding obstacles using radar, the point cloud comprising relative coordinates corresponding to a plurality of obstacles; wherein the plurality of obstacles comprise dynamic obstacles and/or static obstacles;
calculating absolute coordinates of the plurality of obstacles in the point cloud in a world coordinate system by acquiring the absolute coordinates of the acquisition vehicle, establishing a point cloud coordinate system by taking the acquisition vehicle as an origin, and using the relative coordinates of the plurality of obstacles with respect to the acquisition vehicle;
labelling a plurality of first obstacles of the plurality of obstacles in the point cloud based on absolute coordinates of the plurality of first obstacles, so each of the plurality of first obstacles has real labelling data; wherein the real labelling data comprises an absolute coordinate, an orientation, an ID, and a type of each of the plurality of first obstacles;
extracting (S200) the real labelling data of the plurality of first obstacles, and training a plurality of neural network models having different network structures and different parameters based on the real labelling data of the plurality of first obstacles;
extracting (S300) unlabelling data of a plurality of unlabelled second obstacles, other than the plurality of first obstacles, in the point cloud, and inputting the unlabelling data into each of the plurality of neural network models, such that each of the plurality of neural network models output a corresponding prediction result to obtain a plurality of prediction results, wherein each of the plurality of prediction results comprises attribute data, the attribute data comprising an identity recognition, ID, a type and an orientation of an simulation obstacle; the unlabelling data comprises absolute coordinates corresponding to the plurality of unlabelled second obstacles, other than the plurality of first obstacles, in the point cloud;
selecting (S400) at least one simulation obstacle by a following manner: determining whether a plurality of pieces of attribute data in the plurality of prediction results indicate a same obstacle, and in a case that the plurality of pieces of attribute data in the plurality of prediction results indicate the same obstacle, selecting the same obstacle as the simulation obstacle; and
inputting (S500) the attribute data of the selected at least one simulation obstacle into the plurality of neural network models to obtain position coordinates of the selected at least one simulation obstacle, and further obtain a position distribution of the selected at least one simulation obstacle;
wherein the inputting (S500) the attribute data of the selected at least one simulation obstacle into the plurality of neural network models to obtain position coordinates of the selected at least one simulation obstacle comprises:
inputting the attribute data of the selected at least one simulation obstacle into the plurality of neural network models to obtain a plurality of boundary boxes of the at least one simulation obstacle;
obtaining lengths and widths of the boundary boxes of the at least one simulation obstacle;
calculating an average length value and an average width value based on the lengths and widths of the boundary boxes; and
obtaining center coordinates of an average boundary box based on the average length value and the average width value to cause the center coordinates to be represented as position coordinates of the at least one simulation obstacle.

2. The method of claim **1,** wherein after the obtaining the plurality of prediction results, the method further comprises:
outputting confidences corresponding to the plurality of prediction results respectively; and
determining whether the confidences are greater than a threshold, and reserving a prediction result with a confidence greater than the threshold.

3. A obstacle distribution simulation device based on multiple models, the device comprising:
a point cloud acquisition module (10), configured to acquire a plurality of frames of point cloud by an acquisition vehicle moving according to a movement rule by scanning surrounding obstacles using radar, the point cloud comprising relative coordinates corresponding to a plurality of obstacles; wherein the plurality of obstacles comprise dynamic obstacles and/or static obstacles; the point cloud acquisition module (10) is further configured to calculate absolute coordinates of the plurality of obstacles in the point cloud in a world coordinate system by acquiring the absolute coordinates of the acquisition vehicle, establishing a point cloud coordinate system by taking the acquisition vehicle as an origin, and using the relative coordinates of the plurality of obstacles with respect to the acquisition vehicle; and label a plurality of first obstacles of the plurality of obstacles in the point cloud based on absolute coordinates of the plurality of first obstacles, so each of the plurality of first obstacles has real labelling data; wherein the real labelling data comprises an absolute coordinate, an orientation, an ID, and a type of each of the plurality of first obstacles;
a model training module (20), configured to extract the real labelling data of the plurality of first obstacles, and train a plurality of neural network models having different network structures and different parameters based on the real labelling data of the plurality of first obstacles;
a simulation obstacle prediction module (30), configured to extract unlabelling data of a plurality of unlabelled second obstacles, other than the plurality of first obstacles, in the point cloud, and input the unlabelling data into each of the plurality of neural network models, such that each of the plurality of neural network models output a corresponding prediction result to obtain a plurality of prediction results, wherein each of the plurality of prediction results comprises attribute data, the attribute data comprising an identity recognition, ID, a type and an orientation of an simulation obstacle; the unlabelling data comprises absolute coordinates corresponding to the plurality of unlabelled second obstacles, other than the plurality of first obstacles, in the point cloud;
a simulation obstacle selection module (40), configured to select at least one simulation obstacle by a following manner: determining whether a plurality of pieces of attribute data in the plurality of prediction results indicate a same obstacle, and in a case that the plurality of pieces of attribute data in the plurality of prediction results indicate the same obstacle, selecting the same obstacle as the simulation obstacle; and
a simulation obstacle position distribution module (50), configured to input the attribute data of the selected at least one simulation obstacle into the plurality of neural network models to obtain position coordinates of the selected at least one simulation obstacle, and further obtain a position distribution of the selected at least one simulation obstacle;
wherein the simulation obstacle position distribution module (50) comprises:
a boundary box calculation unit (51), configured to input the attribute data of the selected at least one simulation obstacle into the plurality of neural network models to obtain a plurality of boundary boxes of the at least one simulation obstacle;
a length and width calculation unit (52), configured to obtain lengths and widths of the boundary boxes of the at least one simulation obstacle;
an average length and width value calculation unit (53), configured to calculate an average length value and an average width value based on the lengths and widths of the boundary boxes; and
a position coordinate calculation unit (54), configured to obtain center coordinates of an average boundary box based on the average length value and the average width value, to cause the center coordinates to be represented as position coordinates of the at least one simulation obstacle.

4. The device of claim 4, further comprising:
a confidence determination module, configured to output confidences corresponding to the plurality of prediction results respectively, determine whether the confidences are greater than a threshold, and reserve a prediction result with a confidence greater than the threshold.

5. An obstacle distribution simulation terminal based on multiple models, comprising:
one or more processors and a point cloud acquisition module (10), configured to acquire a plurality of frames of point cloud by an acquisition vehicle moving according to a movement rule by scanning surrounding obstacles using a radar;
a storage device configured to store one or more programs;
wherein the one or more programs, when executed by the one or more processors, cause the one or more processors to implement the method of any one of claims 1 to 2.

6. A non-transitory computer readable storage medium, in which a computer program is stored, wherein the program, when executed by the terminal of claim 5, causes the processor to implement the method of any one of claims 1 to 2.

## Patentansprüche

1. Computerimplementiertes Hindernisverteilungssimulationsverfahren basierend auf mehreren Modellen, umfassend:
Erfassen (S100) einer Vielzahl von Rahmen von Punktwolke durch ein Erfassungsfahrzeug, das sich gemäß einer Bewegungsregel bewegt, durch Abtasten umgebender Hindernisse unter Verwendung von Radar, wobei die Punktwolke relative Koordinaten entsprechend einer Vielzahl von Hindernissen umfasst; wobei die Vielzahl von Hindernissen dynamische Hindernisse und/oder statische Hindernisse umfasst;
Berechnen absoluter Koordinaten der Vielzahl von Hindernissen in der Punktwolke in einem Weltkoordinatensystem durch Erfassen der absoluten Koordinaten des Erfassungsfahrzeugs, Etablieren eines Punktwolkenkoordinatensystems durch Nehmen des Erfassungsfahrzeugs als Ursprung, und Verwenden der relativen Koordinaten der Vielzahl von Hindernissen in Bezug auf das Erfassungsfahrzeug;
Kennzeichnen einer Vielzahl von ersten Hindernissen der Vielzahl von Hindernissen in der Punktwolke basierend auf absoluten Koordinaten der Vielzahl von ersten Hindernissen, so dass jedes der Vielzahl von ersten Hindernissen echte Kennzeichnungsdaten hat; wobei die echten Kennzeichnungsdaten eine absolute Koordinate, eine Orientierung, eine ID und einen Typ von jedem der Vielzahl von ersten Hindernissen umfassen;
Extrahieren (S200) der echten Kennzeichnungsdaten der Vielzahl von ersten Hindernissen, und Trainieren einer Vielzahl von neuronalen Netzwerkmodellen, die verschiedene Netzwerkstrukturen und verschiedene Parameter haben, basierend auf den echten Kennzeichnungsdaten der Vielzahl von ersten Hindernissen;
Extrahieren (S300) nicht kennzeichnender Daten einer Vielzahl von nicht gekennzeichneten zweiten Hindernissen, andere als die Vielzahl von ersten Hindernissen, in der Punktwolke, und Eingeben der nicht kennzeichnenden Daten in jedes der Vielzahl von neuronalen Netzwerkmodellen, so dass jedes der Vielzahl von neuronalen Netzwerkmodellen ein entsprechendes Vorhersageergebnis ausgibt, um eine Vielzahl von Vorhersageergebnissen zu erhalten, wobei jedes der Vielzahl von Vorhersageergebnissen Attributdaten umfasst, wobei die Attributdaten eine Identitätserkennung, ID, einen Typ und eine Orientierung eines Simulationshindernisses umfassen; die nicht kennzeichnenden Daten umfassen absolute Koordinaten entsprechend der Vielzahl von nicht gekennzeichneten zweiten Hindernissen, andere als die Vielzahl von ersten Hindernissen, in der Punktwolke;
Auswählen (S400) mindestens eines Simulationshindernisses durch eine folgende Weise: Bestimmen, ob eine Vielzahl von Stücken von Attributdaten in der Vielzahl von Vorhersageergebnissen dasselbe Hindernis anzeigen, und in einem Fall, dass die Vielzahl von Stücken von Attributdaten in der Vielzahl von Vorhersageergebnissen dasselbe Hindernis anzeigen, Auswählen desselben Hindernisses als das Simulationshindernis; und
Eingeben (S500) der Attributdaten des ausgewählten mindestens einen Simulationshindernisses in die Vielzahl von neuronalen Netzwerkmodellen, um Positionskoordinaten des ausgewählten mindestens einen Simulationshindernisses zu erhalten, und ferner eine Positionsverteilung des ausgewählten mindestens einen Simulationshindernisses zu erhalten;
wobei das Eingeben (S500) der Attributdaten des ausgewählten mindestens einen Simulationshindernisses in die Vielzahl von neuronalen Netzwerkmodellen, um Positionskoordinaten des ausgewählten mindestens einen Simulationshindernisses zu erhalten, umfasst:
Eingeben der Attributdaten des ausgewählten mindestens einen Simulationshindernisses in die Vielzahl von neuronalen Netzwerkmodellen, um eine Vielzahl von Begrenzungsrahmen des mindestens einen Simulationshindernisses zu erhalten;
Erhalten von Längen und Breiten der Begrenzungsrahmen des mindestens einen Simulationshindernisses;
Berechnen eines durchschnittlichen Längenwerts und eines durchschnittlichen Breitenwerts basierend auf den Längen und Breiten der Begrenzungsrahmen; und
Erhalten von Mittelkoordinaten eines durchschnittlichen Begrenzungsrahmens basierend auf dem durchschnittlichen Längenwert und dem durchschnittlichen Breitenwert, um zu bewirken, dass die Mittelkoordinaten als Positionskoordinaten des mindestens einen Simulationshindernisses dargestellt werden.

2. Verfahren nach Anspruch 1, wobei nach dem Erhalten der Vielzahl von Vorhersageergebnissen das Verfahren ferner umfasst:
Ausgeben von Vertrauenswerten entsprechend der Vielzahl von Vorhersageergebnissen jeweils; und
Bestimmen, ob die Vertrauenswerte größer als ein Schwellenwert sind, und Reservieren eines Vorhersageergebnisses mit einem Vertrauenswert größer als der Schwellenwert.

3. Hindernisverteilungssimulationsvorrichtung basierend auf mehreren Modellen, wobei die Vorrichtung umfasst:
ein Punktwolkenerfassungsmodul (10), das konfiguriert ist, eine Vielzahl von Rahmen von Punktwolke durch ein Erfassungsfahrzeug zu erfassen, das sich gemäß einer Bewegungsregel bewegt, durch Abtasten umgebender Hindernisse unter Verwendung von Radar, wobei die Punktwolke relative Koordinaten entsprechend einer Vielzahl von Hindernissen umfasst; wobei die Vielzahl von Hindernissen dynamische Hindernisse und/oder statische Hindernisse umfasst; das Punktwolkenerfassungsmodul (10) ist ferner konfiguriert, absolute Koordinaten der Vielzahl von Hindernissen in der Punktwolke in einem Weltkoordinatensystem zu berechnen durch Erfassen der absoluten Koordinaten des Erfassungsfahrzeugs, Etablieren eines Punktwolkenkoordinatensystems durch Nehmen des Erfassungsfahrzeugs als Ursprung, und Verwenden der relativen Koordinaten der Vielzahl von Hindernissen in Bezug auf das Erfassungsfahrzeug; und eine Vielzahl von ersten Hindernissen der Vielzahl von Hindernissen in der Punktwolke zu kennzeichnen basierend auf absoluten Koordinaten der Vielzahl von ersten Hindernissen, so dass jedes der Vielzahl von ersten Hindernissen echte Kennzeichnungsdaten hat;
wobei die echten Kennzeichnungsdaten eine absolute Koordinate, eine Orientierung, eine ID und einen Typ von jedem der Vielzahl von ersten Hindernissen umfassen;
ein Modelltrainingsmodul (20), das konfiguriert ist, die echten Kennzeichnungsdaten der Vielzahl von ersten Hindernissen zu extrahieren, und eine Vielzahl von neuronalen Netzwerkmodellen zu trainieren, die verschiedene Netzwerkstrukturen und verschiedene Parameter haben, basierend auf den echten Kennzeichnungsdaten der Vielzahl von ersten Hindernissen;
ein Simulationshindernisvorhersagemodul (30), das konfiguriert ist, nicht kennzeichnende Daten einer Vielzahl von nicht gekennzeichneten zweiten Hindernissen, andere als die Vielzahl von ersten Hindernissen, in der Punktwolke zu extrahieren, und die nicht kennzeichnenden Daten in jedes der Vielzahl von neuronalen Netzwerkmodellen einzugeben, so dass jedes der Vielzahl von neuronalen Netzwerkmodellen ein entsprechendes Vorhersageergebnis ausgibt, um eine Vielzahl von Vorhersageergebnissen zu erhalten, wobei jedes der Vielzahl von Vorhersageergebnissen Attributdaten umfasst, wobei die Attributdaten eine Identitätserkennung, ID, einen Typ und eine Orientierung eines Simulationshindernisses umfassen; die nicht kennzeichnenden Daten umfassen absolute Koordinaten entsprechend der Vielzahl von nicht gekennzeichneten zweiten Hindernissen, andere als die Vielzahl von ersten Hindernissen, in der Punktwolke;
ein Simulationshindernisauswahlmodul (40), das konfiguriert ist, mindestens ein Simulationshindernis durch eine folgende Weise auszuwählen: Bestimmen, ob eine Vielzahl von Stücken von Attributdaten in der Vielzahl von Vorhersageergebnissen dasselbe Hindernis anzeigen, und in einem Fall, dass die Vielzahl von Stücken von Attributdaten in der Vielzahl von Vorhersageergebnissen dasselbe Hindernis anzeigen, Auswählen desselben Hindernisses als das Simulationshindernis; und
ein Simulationshindernispositionsverteilungsmodul (50), das konfiguriert ist, die Attributdaten des ausgewählten mindestens einen Simulationshindernisses in die Vielzahl von neuronalen Netzwerkmodellen einzugeben, um Positionskoordinaten des ausgewählten mindestens einen Simulationshindernisses zu erhalten, und ferner eine Positionsverteilung des ausgewählten mindestens einen Simulationshindernisses zu erhalten;
wobei das Simulationshindernispositionsverteilungsmodul (50) umfasst:
eine Begrenzungsrahmenberechnungseinheit (51), die konfiguriert ist, die Attributdaten des ausgewählten mindestens einen Simulationshindernisses in die Vielzahl von neuronalen Netzwerkmodellen einzugeben, um eine Vielzahl von Begrenzungsrahmen des mindestens einen Simulationshindernisses zu erhalten;
eine Längen- und Breitenberechnungseinheit (52), die konfiguriert ist, Längen und Breiten der Begrenzungsrahmen des mindestens einen Simulationshindernisses zu erhalten;
eine Durchschnittslängen- und -breitenwertberechnungseinheit (53), die konfiguriert ist, einen durchschnittlichen Längenwert und einen durchschnittlichen Breitenwert basierend auf den Längen und Breiten der Begrenzungsrahmen zu berechnen; und
eine Positionskoordinatenberechnungseinheit (54), die konfiguriert ist, Mittelkoordinaten eines durchschnittlichen Begrenzungsrahmens basierend auf dem durchschnittlichen Längenwert und dem durchschnittlichen Breitenwert zu erhalten, um zu bewirken, dass die Mittelkoordinaten als Positionskoordinaten des mindestens einen Simulationshindernisses dargestellt werden.

4. Vorrichtung nach Anspruch 3, ferner umfassend:
ein Vertrauenswertbestimmungsmodul, das konfiguriert ist, Vertrauenswerte entsprechend der Vielzahl von Vorhersageergebnissen jeweils auszugeben, zu bestimmen, ob die Vertrauenswerte größer als ein Schwellenwert sind, und ein Vorhersageergebnis mit einem Vertrauenswert größer als der Schwellenwert zu reservieren.

5. Hindernisverteilungssimulationsterminal basierend auf mehreren Modellen, umfassend:
einen oder mehrere Prozessoren und ein Punktwolkenerfassungsmodul (10), das konfiguriert ist, eine Vielzahl von Rahmen von Punktwolke durch ein Erfassungsfahrzeug zu erfassen, das sich gemäß einer Bewegungsregel bewegt, durch Abtasten umgebender Hindernisse unter Verwendung eines Radars;
eine Speichervorrichtung, die konfiguriert ist, ein oder mehrere Programme zu speichern;
wobei das eine oder die mehreren Programme, wenn sie durch den einen oder die mehreren Prozessoren ausgeführt werden, den einen oder die mehreren Prozessoren veranlassen, das Verfahren nach einem der Ansprüche 1 bis 2 zu implementieren.

6. Nichtflüchtiges computerlesbares Speichermedium, in dem ein Computerprogramm gespeichert ist, wobei das Programm, wenn es durch das Terminal nach Anspruch 5 ausgeführt wird, den Prozessor veranlasst, das Verfahren nach einem der Ansprüche 1 bis 2 zu implementieren.

## Revendications

1. Procédé de simulation de distribution d'obstacles mis en œuvre par ordinateur basé sur modèles multiples, comprenant :
l'acquisition (S100) d'une pluralité de trames de nuage de points par un véhicule d'acquisition qui se déplace selon une règle de mouvement en balayant des obstacles environnants en utilisant un radar, le nuage de points comprenant des coordonnées relatives correspondant à une pluralité d'obstacles ; dans lequel la pluralité d'obstacles comprend des obstacles dynamiques et/ou des obstacles statiques ;
le calcul de coordonnées absolues de la pluralité d'obstacles dans le nuage de points dans un système de coordonnées mondiales en acquérant les coordonnées absolues du véhicule d'acquisition, en établissant un système de coordonnées de nuage de points en prenant le véhicule d'acquisition comme origine, et en utilisant les coordonnées relatives de la pluralité d'obstacles par rapport au véhicule d'acquisition ;
l'étiquetage d'une pluralité de premiers obstacles de la pluralité d'obstacles dans le nuage de points basé sur les coordonnées absolues de la pluralité de premiers obstacles, de sorte que chacun de la pluralité de premiers obstacles a des données d'étiquetage réelles ; dans lequel les données d'étiquetage réelles comprennent une coordonnée absolue, une orientation, un ID, et un type de chacun de la pluralité de premiers obstacles ;
l'extraction (S200) des données d'étiquetage réelles de la pluralité de premiers obstacles, et l'entraînement d'une pluralité de modèles de réseaux de neurones ayant différentes structures de réseau et différents paramètres basés sur les données d'étiquetage réelles de la pluralité de premiers obstacles ;
l'extraction (S300) de données non-étiquetées d'une pluralité de seconds obstacles non-étiquetés, autres que la pluralité de premiers obstacles, dans le nuage de points, et la saisie des données non-étiquetées dans chacun de la pluralité de modèles de réseaux de neurones, de telle sorte que chacun de la pluralité de modèles de réseaux de neurones produit un résultat de prédiction correspondant pour obtenir une pluralité de résultats de prédiction, dans lequel chacun de la pluralité de résultats de prédiction comprend des données d'attribut, les données d'attribut comprenant une reconnaissance d'identité, un ID, un type et une orientation d'un obstacle de simulation ; les données non-étiquetées comprennent des coordonnées absolues correspondant à la pluralité de seconds obstacles non-étiquetés, autres que la pluralité de premiers obstacles, dans le nuage de points ;
la sélection (S400) d'au moins un obstacle de simulation par la manière suivante : déterminer si une pluralité de pièces de données d'attribut dans la pluralité de résultats de prédiction indiquent un même obstacle, et dans un cas où la pluralité de pièces de données d'attribut dans la pluralité de résultats de prédiction indiquent le même obstacle, sélectionner le même obstacle comme l'obstacle de simulation ; et
la saisie (S500) des données d'attribut de l'au moins un obstacle de simulation sélectionné dans la pluralité de modèles de réseaux de neurones pour obtenir des coordonnées de position de l'au moins un obstacle de simulation sélectionné, et obtenir en outre une distribution de position de l'au moins un obstacle de simulation sélectionné ;
dans lequel la saisie (S500) des données d'attribut de l'au moins un obstacle de simulation sélectionné dans la pluralité de modèles de réseaux de neurones pour obtenir des coordonnées de position de l'au moins un obstacle de simulation sélectionné comprend :
la saisie des données d'attribut de l'au moins un obstacle de simulation sélectionné dans la pluralité de modèles de réseaux de neurones pour obtenir une pluralité de boîtes englobantes de l'au moins un obstacle de simulation ;
l'obtention de longueurs et largeurs des boîtes englobantes de l'au moins un obstacle de simulation
le calcul d'une valeur de longueur moyenne et d'une valeur de largeur moyenne basées sur les longueurs et largeurs des boîtes englobantes ; et
l'obtention de coordonnées centrales d'une boîte englobante moyenne basée sur la valeur de longueur moyenne et la valeur de largeur moyenne pour faire que les coordonnées centrales soient représentées comme coordonnées de position de l'au moins un obstacle de simulation.

2. Procédé selon la revendication 1, dans lequel après l'obtention de la pluralité de résultats de prédiction, le procédé comprend en outre :
la production de niveaux de confiance correspondant respectivement à la pluralité de résultats de prédiction ; et
la détermination de si les niveaux de confiance sont supérieurs à un seuil, et la réservation d'un résultat de prédiction avec un niveau de confiance supérieur au seuil.

3. Dispositif de simulation de distribution d'obstacles basé sur modèles multiples, le dispositif comprenant :
un module d'acquisition de nuage de points (10), configuré pour acquérir une pluralité de trames de nuage de points par un véhicule d'acquisition qui se déplace selon une règle de mouvement en balayant des obstacles environnants en utilisant un radar, le nuage de points comprenant des coordonnées relatives correspondant à une pluralité d'obstacles ; dans lequel la pluralité d'obstacles comprend des obstacles dynamiques et/ou des obstacles statiques ; le module d'acquisition de nuage de points (10) est en outre configuré pour calculer des coordonnées absolues de la pluralité d'obstacles dans le nuage de points dans un système de coordonnées mondiales en acquérant les coordonnées absolues du véhicule d'acquisition, en établissant un système de coordonnées de nuage de points en prenant le véhicule d'acquisition comme origine, et en utilisant les coordonnées relatives de la pluralité d'obstacles par rapport au véhicule d'acquisition ; et étiqueter une pluralité de premiers obstacles de la pluralité d'obstacles dans le nuage de points basé sur les coordonnées absolues de la pluralité de premiers obstacles, de sorte que chacun de la pluralité de premiers obstacles a des données d'étiquetage réelles ; dans lequel les données d'étiquetage réelles comprennent une coordonnée absolue, une orientation, un ID, et un type de chacun de la pluralité de premiers obstacles ;
un module d'entraînement de modèle (20), configuré pour extraire les données d'étiquetage réelles de la pluralité de premiers obstacles, et entraîner une pluralité de modèles de réseaux de neurones ayant différentes structures de réseau et différents paramètres basés sur les données d'étiquetage réelles de la pluralité de premiers obstacles ;
un module de prédiction d'obstacles de simulation (30), configuré pour extraire des données non-étiquetées d'une pluralité de seconds obstacles non-étiquetés, autres que la pluralité de premiers obstacles, dans le nuage de points, et saisir les données non-étiquetées dans chacun de la pluralité de modèles de réseaux de neurones, de telle sorte que chacun de la pluralité de modèles de réseaux de neurones produit un résultat de prédiction correspondant pour obtenir une pluralité de résultats de prédiction, dans lequel chacun de la pluralité de résultats de prédiction comprend des données d'attribut, les données d'attribut comprenant une reconnaissance d'identité, un ID, un type et une orientation d'un obstacle de simulation ; les données non-étiquetées comprennent des coordonnées absolues correspondant à la pluralité de seconds obstacles non-étiquetés, autres que la pluralité de premiers obstacles, dans le nuage de points ;
un module de sélection d'obstacles de simulation (40), configuré pour sélectionner au moins un obstacle de simulation par la manière suivante : déterminer si une pluralité de pièces de données d'attribut dans la pluralité de résultats de prédiction indiquent un même obstacle, et dans un cas où la pluralité de pièces de données d'attribut dans la pluralité de résultats de prédiction indiquent le même obstacle, sélectionner le même obstacle comme l'obstacle de simulation ; et
un module de distribution de position d'obstacles de simulation (50), configuré pour saisir les données d'attribut de l'au moins un obstacle de simulation sélectionné dans la pluralité de modèles de réseaux de neurones pour obtenir des coordonnées de position de l'au moins un obstacle de simulation sélectionné, et obtenir en outre une distribution de position de l'au moins un obstacle de simulation sélectionné ;
dans lequel le module de distribution de position d'obstacles de simulation (50) comprend :
une unité de calcul de boîte englobante (51), configurée pour saisir les données d'attribut de l'au moins un obstacle de simulation sélectionné dans la pluralité de modèles de réseaux de neurones pour obtenir une pluralité de boîtes englobantes de l'au moins un obstacle de simulation ;
une unité de calcul de longueur et largeur (52), configurée pour obtenir des longueurs et largeurs des boîtes englobantes de l'au moins un obstacle de simulation ;
une unité de calcul de valeur de longueur et largeur moyennes (53), configurée pour calculer une valeur de longueur moyenne et une valeur de largeur moyenne basées sur les longueurs et largeurs des boîtes englobantes ; et
une unité de calcul de coordonnées de position (54), configurée pour obtenir des coordonnées centrales d'une boîte englobante moyenne basée sur la valeur de longueur moyenne et la valeur de largeur moyenne, pour faire que les coordonnées centrales soient représentées comme coordonnées de position de l'au moins un obstacle de simulation.

4. Dispositif selon la revendication 3, comprenant en outre :
un module de détermination de niveau de confiance, configuré pour produire des niveaux de confiance correspondant respectivement à la pluralité de résultats de prédiction, déterminer si les niveaux de confiance sont supérieurs à un seuil, et réserver un résultat de prédiction avec un niveau de confiance supérieur au seuil.

5. Terminal de simulation de distribution d'obstacles basé sur modèles multiples, comprenant :
un ou plusieurs processeurs et un module d'acquisition de nuage de points (10), configuré pour acquérir une pluralité de trames de nuage de points par un véhicule d'acquisition qui se déplace selon une règle de mouvement en balayant des obstacles environnants en utilisant un radar ;
un dispositif de stockage configuré pour stocker un ou plusieurs programmes ;
dans lequel le ou les programmes, lorsqu'ils sont exécutés par le ou les processeurs, font que le ou les processeurs mettent en œuvre le procédé selon l'une quelconque des revendications 1 à 2.

6. Support de stockage lisible par ordinateur non-transitoire, dans lequel un programme informatique est stocké, dans lequel le programme, lorsqu'il est exécuté par le terminal selon la revendication 5, fait que le processeur met en œuvre le procédé selon l'une quelconque des revendications 1 à 2.
